# EUROPÄISCHE PATENTSCHRIFT

(11) **EP 1 204 301 B1**
(45) Veröffentlichungstag und Bekanntmachung des Hinweises auf die Patenterteilung: **07.01.2009**
(21) Anmeldenummer: 01124306.0
(22) Anmeldetag: 19.10.2001
(51) Int. Cl.: H05K 1/02

(54) **Aufbau zur Bildung einer Eingangsschaltung zur Aufnahme und Verarbeitung eines elektrischen Signals**
Arrangement for forming an input circuit for recording and processing an electrical signal
Agencement pour constituer un circuit d'entrée pour l'enregistrement et le traitement d'un signal électrique

(30) Priorität: 23.10.2000 DE 10052532
(43) Veröffentlichungstag der Anmeldung: 08.05.2002
(73) Patentinhaber: Endress + Hauser Conducta Gesellschaft für Mess- und Regeltechnik mbH + Co.KG., 70839 Gerlingen (DE)
(72) Erfinder: Gehrke, Martin, 71384 Weinstadt (DE); Pechstein, Torsten, Dr.-Ing., 01455 Radebeul (DE)
(74) Vertreter: Andres, Angelika Maria

(56) Entgegenhaltungen:
- WO-A-00/16443
- DE-A- 19 810 736
- US-A- 4 278 707
- PATENT ABSTRACTS OF JAPAN vol. 015, no. 004 (E-1020), 8. Januar 1991 (1991-01-08) & JP 02 260694 A (JAPAN RADIO CO LTD), 23. Oktober 1990 (1990-10-23)
- PATENT ABSTRACTS OF JAPAN vol. 010, no. 175 (E-413), 20. Juni 1986 (1986-06-20) & JP 61 024253 A (HITACHI LTD), 1. Februar 1986 (1986-02-01)
- PATENT ABSTRACTS OF JAPAN vol. 012, no. 256 (E-635), 19. Juli 1988 (1988-07-19) & JP 63 044745 A (IBIDEN CO LTD), 25. Februar 1988 (1988-02-25)
- PATENT ABSTRACTS OF JAPAN vol. 011, no. 083 (E-489), 13. März 1987 (1987-03-13) & JP 61 237454 A (TOSHIBA CORP), 22. Oktober 1986 (1986-10-22)

## Beschreibung

Die Erfindung betrifft einen Aufbau zur Bildung einer Eingangsschaltung zur Aufnahme und Verarbeitung eines elektrischen Signals, wie eines Spannungsignals, einer Spannungsquelle, insbesondere eines Sensors, wie eines elektrochemischen, induktiven oder optischen Sensors, wobei die Eingangschaltung einen sehr hohen Eingangswiderstand von wenigstens 10¹¹ Ohm aufweist und auf einer Leiterplatte angeordnet ist, wobei ein erster Bauelemente der Eingangsschaltung tragender Bereich der Leiterplatte von einem zweiten ihn umgebenden oder an ihn angrenzenden Bereich durch eine schlitzförmige Ausnehmung getrennt ist.

Im Besonderen betrifft die vorliegende Erfindung eine Eingangsschaltung einer Messwertverarbeitungseinrichtung zum Betrieb eines Sensors, insbesondere eines elektrochemischen Sensors zur pH-Messung. Die Elektroden des Sensors stellen dabei eine Spannungsquelle mit einem Innenwiderstand von bis zu 1 GOhm dar. Um diese Spannungen und damit Messsignale des Sensors aufnehmen und verarbeiten zu können, ist eine geeignete Eingangsschaltung erforderlich, welche die Spannungsquelle so wenig belastet, dass der in folge der Messsignalaufnahme und -verarbeitung entstehende Fehler geringer als der akzeptierbare Messfehler ist. Üblicherweise wird hier ein um den Faktor 1000 höherer Eingangswiderstand als der Innenwiderstand der Elektrodenanordnung des Sensors gefordert. Der Eingangswiderstand muss wenigstens 10¹¹ Ohm aufweisen, weist vorzugsweise 5 x 10¹¹ Ohm und bevorzugtermaßen 10¹² Ohm und mehr auf.

Eine Eingangsschaltung, insbesondere zur Erfassung des Messsignals einer pH-sensitiven Elektrodenanordnung umfasst üblicherweise einen hochohmigen Operationsverstärker, der als Buffer (1-Verstärkung) geschaltet ist und damit eine Messsignalverstärkung für die Weiterverarbeitung der Messspannung ausführt. Wird eine solche Eingangsschaltung auf einem konventionellen Leiterplattenmaterial, insbesondere FR4-Material, aufgebaut, so funktioniert sie nur unter Laborbedingungen zuverlässig, da unter Laborbedingungen (geeignete Temperatur, niedrige Luftfeuchtigkeit) kaum Leckströme über das Basismaterial der Leiterkarte und deren Oberfläche sowie der Oberfläche der betreffenden Bauteile abfließen. Wird die Eingangsschaltung aber bei Betriebsbedingungen einer höheren Luftfeuchtigkeit und Temperatur ausgesetzt (z.B. 60°, 95 % rF), so besteht die Gefahr einer Messwertverfälschung durch Leckströme über das infolge Eindringen der Wassermoleküle niederohmiger werdende Basismaterial der Leiterkarte, sowie durch Strombrücken z.B. über angelöste Schmutzteilchen auf den Oberflächen der Bauteile der Eingangsschaltung und der Leiterkarte. Ohne besondere Maßnahmen kann das Eindringen von Feuchtigkeit in das Basismaterial üblicher Leiterkarten nicht verhindert werden. Übliche Leiterkarten sind auf Basis eines glasfaserverstärkten Epoxy-Harzes aufgebaut und typischerweise feuchtigkeitsaufnahmefähig. Wassermoleküle können sich nämlich in die chemische Struktur des Epoxy-Harzes einlagern. Desweiteren können Wassermoleküle durch Kapillarwirkung an den Grenzflächen zwischen Epoxy-Harz und eingelagerten Glasfasern ins Leiterplatteninnere wandern.

Dieses Problem wurde bislang durch die Verwendung von keramischem Basismaterial (sog. Hybridleiterplatten) und einer Kapselung der Eingangsschaltung mittels eines hochgefüllten, Epoxy-basierenden Vergussmaterials gelöst. Diese Lösung ist jedoch relativ kostspielig aufgrund der teuren Materialien und mit einer zeitintensiven Fertigung verbunden.

Mit der DE 198 10 736 A1 der Anmelderin wurde ein Messeingang für eine hochohmige Eingangsschaltung vorgeschlagen, wobei ein dem Messeingang zugeordneter Abschnitt der Leiterplatte durch einen durch die Leiterplatte hindurchgehenden Trennspalt von den übrigen Bereichen der Leiterplatte isoliert ist und einen Anschluss zu einem Operationsverstärker aufweist, der allerdings nicht auf dem isolierten Leiterplattenabschnitt vorgesehen ist. Eine solche hochohmige Eingangsschaltung nach DE 198 10 736 A1 konnte durch Bestückung der Leiterplatte in einem Bestückungsautomaten und anschließender Bildung eines inselförmigen Abschnitts als Messeingang der Schaltung zwar auf wirtschaftliche Weise hergestellt werden. Hiervon ausgehend liegt der vorliegenden Erfindung die Aufgabe zugrunde, der Einwirkung von Feuchtigkeit auf die Eingangsschaltung wirksam zu begegnen.

Desweiteren war es, wie eingangs bereits erwähnt, bekannt, als Basismaterial anstelle konventioneller Leiterplattenmaterialien (FR4-Material) ein keramisches Basismaterial (Hybrid-Leiterplatte) zu verwenden und hierauf die Bauelemente der Eingangsschaltung anzuordnen. Durch eine Kapselung der Eingangsschaltung mit einer hochgefüllten, Epoxy-basierenden Gussmasse konnten die erforderlichen Eingangswiderstände der Eingangsschaltung erreicht werden. Diese Lösung ist jedoch, wie bereits erwähnt, kostspielig und in der Fertigung zeitintensiv.

Demgegenüber sollte eine preiswertere Herstellbarkeit erreicht werden.

Die vorstehenden Aufgabenaspekte werden bei einer hochohmigen Eingangsschaltung der gattungsgemäßen Art erfindungsgemäß dadurch gelöst, dass die schlitzförmige Ausnehmung im Inneren der Leiterplatte endet, also zumindest abschnittsweise keinen durch die Leiterplatte hindurchgehenden Trennschlitz nach DE 198 10 736 A1 bildet, und in Dickenrichtung der Leiterplatte unmittelbar bis zu einer den ersten Bereich der Leiterplatte unterfangenden feuchtigkeitsundurchlässigen Barriereschicht (Diffusionssperrschicht) erstreckt ist und dass die schlitzförmige Ausnehmung und der erste Bereich mit einer zusammenhängenden feuchtigkeitsundurchlässigen Vergussmasse aus- und umgossen sind.

Die hochohmigen Schaltungskomponenten der Eingangsschaltung sind also auf dem ersten Bereich, der aus konventionellem Leiterplattenmaterial, insbesondere FR4-Leiterplattenmaterial, gebildet ist, aufgebracht und durch die feuchtigkeitsundurchlässige Vergussmasse überfangen. Dieser erste Leiterplattenbereich ist nach unten oder nach innen feuchtigkeitsdicht abgeschlossen und isoliert, und zwar durch die feuchtigkeitsundurchlässige Barriereschicht einerseits und seitlich durch die die umlaufende schlitzförmige Ausnehmung ausfüllende Vergussmasse. Dadurch, dass die umlaufende schlitzförmige Ausnehmung bis zu der feuchtigkeitsundurchlässigen Barriereschicht erstreckt ist, ist eine vollständige Feuchtigkeitsabdichtung des ersten Leiterplattenbereichs erreicht. Wenn also Feuchtigkeit, welche in das Leiterplattenmaterial eingedrungen ist, von innen in Richtung auf den ersten Bereich, auf dem die Eingangsschaltung angeordnet ist, vordringt, so wird die Feuchtigkeit von der feuchtigkeitsundurchlässigen Barriereschicht und durch die die schlitzförmige Ausnehmung ausfüllende Vergussmasse an einem Voranschreiten zu den Schaltungskomponenten gehindert. Die feuchtigkeitsundurchlässige Barriereschicht kann auf beliebige Weise erhalten oder ausgebildet werden, solange eine wirksame Sperrwirkung gegen eindringende Feuchtigkeit erreicht wird. Es hat sich als vorteilhaft erwiesen, wenn die feuchtigkeitsundurchlässige Barriereschicht von einer metallischen Schicht innerhalb der Leiterplatte gebildet ist. Diese metallische Schicht ist vorzugsweise eben, sie ist unterhalb des ersten Bereichs durchgehend, also ohne Unterbrechungen ausgebildet. Bei dem Ausgangsmaterial der Leiterplatte kann es sich um eine kupferkaschierte Leiterplatte, insbesondere auch um eine Multilayer-Leiterplatte handeln.

Im Hinblick auf eine kostengünstige Herstellbarkeit der Leiterplatte erweist es sich als vorteilhaft, wenn diese von einem konventionellen FR4-Material gebildet ist, welches zumindest eine feuchtigkeitsundurchlässige Barriereschicht im Inneren aufweist.

Es hat sich desweiteren als ganz besonders vorteilhaft erwiesen, wenn die die schlitzförmige Ausnehmung begrenzenden Wandungen der Leiterplatte vor dem Eingießen durch die Vergussmasse ihrerseits mit einer feuchtigkeitsundurchlässigen Beschichtung, insbesondere in Form einer Metallisierung, versehen worden sind. Diese feuchtigkeitsundurchlässige Beschichtung steht dann in unmittelbarem Kontakt zu der feuchtigkeitsundurchlässigen Barriereschicht, welche den ersten Bereich der Leiterplatte unterfängt und gegen Feuchtigkeit abdichtet. Die feuchtigkeitsundurchlässige Vergussmasse ist beispielsweise auf Epoxy-Basis oder auf Basis eines HD-Polyethylen oder auf Schmelzharz-Basis hergestellt.

Weitere Merkmale, Einzelheiten und Vorteile der Erfindung ergeben sich aus den beigefügten Patentansprüchen und aus der zeichnerischen Darstellung und nachfolgenden Beschreibung einer bevorzugten Ausführungsform der Erfindung. In der Zeichnung zeigt:
- Figur 1: eine schematische Draufsicht auf eine Leiterkarte mit einer erfindungsgemäßen Eingangsschaltung (schematisch angedeutet) für das Messsignal eines Sensors; und
- Figur 2: eine Schnittansicht einer Leiterplatte mit schematisch angedeuteter Eingangsschaltung.

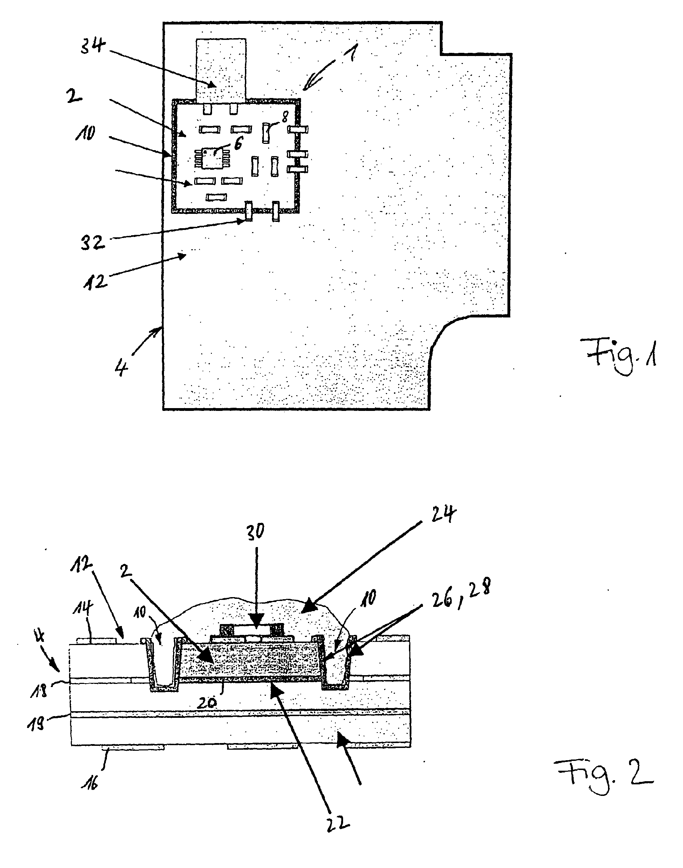

Figur 1 zeigt eine Draufsicht auf eine Leiterkarte mit einer hochohmigen Eingangsschaltung 1 für das Messsignal eines pH-Sensors auf Glasbasis, wobei eine Elektrode des Sensors von einer Glaskapselung eines Messzellenelektrolyten gebildet ist.

Die Eingangsschaltung 1 ist auf einem ersten Leiterplattenbereich 2 einer insgesamt mit dem Bezugszeichen 4 bezeichneten Leiterplatte 4 aus einem konventionellen FR4-Material angeordnet und umfasst elektrische und elektronische Bauteile, wie einen Operationsverstärker 6, Widerstände 8, Kondensatoren. Der erste Leiterplattenbereich 2, welcher einen hochhohmigen Teil der Leiterkarte bildet, ist durch eine umlaufende schlitzförmige Ausnehmung 10 von dem übrigen zweiten Bereich 12 der Leiterplatte 4 in der Draufsicht der Figur 1 getrennt.

Die Figur 2 zeigt eine schematische Schnittansicht des Aufbaus der Leiterplatte 4 mit der Eingangsschaltung, wobei die Darstellung keiner bestimmten Schnittebene in Figur 1 zugeordnet werden kann, sondern den Aufbau nur schematisch wiedergibt, wobei entsprechende Teile mit demselben Bezugszeichen versehen sind. So zeigt Figur 2 eine aus drei Schichten von FR4-Material gebildete Leiterplatte 4, die beidseits kupferkaschiert ausgebildet ist, wobei die äußeren Kupferschichten 14, 16 im Zuge der Herstellung teilweise Unterbrechungen erhalten haben. Die Leiterplatte 4 umfasst im Inneren weitere metallische Schichten 18, 19. Der zuvor bei Figur 1 erwähnte erste Leiterplattenbereich 2 ist durch die umlaufende schlitzförmige Ausnehmung 10 begrenzt und hierdurch von dem übrigen zweiten Leiterplattenbereich 12 in der Draufsicht der Figur 1 getrennt. Wie aus Figur 2 ersichtlich ist, endet die schlitzförmige Ausnehmung 10 im Inneren der Leiterplatte 4.

Es ist also keine durchgehende Insel wie nach der eingangs erwähnten DE 198 01 736 A1 gebildet. Es wäre jedoch nicht ausgeschlossen, dass die schlitzförmige Ausnehmung abschnittsweise sich bis zur anderen Seite hindurch erstrecken könnte. Wesentlich ist aber, dass bei der Anbringung der schlitzförmigen Ausnehmung, etwa durch Kerb-Fräsen, die Schicht 18, welche den ersten Bereich 2 der Leiterplatte 4 unterfängt, erreicht wird. Dieser Bereich der Schicht 18 bildet nämlich eine flüssigkeits- und feuchtigkeitsundurchlässige Barriereschicht, so dass eine feuchtigkeitsdichte Einkapselung des ersten Bereichs 2 und der darauf angeordneten Eingangsschaltung erreicht wird. Zumindest derjenige Abschnitt 22 der den ersten Bereich 2 unterfangenden Schicht 18 ist feuchtigkeitsundurchlässig und bildet die Barriereschicht 20; es handelt sich vorzugsweise um eine metallische Schicht 18. An diesen Abschnitt 22 bzw. die Barriereschicht 20 kann dann entweder eine feuchtigkeitsundurchlässige Vergussmasse 24, welche auch in die schlitzförmige Ausnehmung 10 eingegossen wird, unmittelbar angrenzen und so eine feuchtigkeitsundurchlässige Einkapselung bilden, oder - wie im dargestellten Fall der Figur 2 - sind Wandungen 26 der Leiterplatte, welche die schlitzförmige Ausnehmung 10 begrenzen, mit einer solchen feuchtigkeitsundurchlässigen Schicht, vorzugsweise einer Metallisierung 28 versehen, welche ihrerseits an die Barriereschicht 20 angrenzt und entlang deren Ränder durchgehend flüssigkeitsdicht mit dieser verbunden ist. Auf diese Weise ist eine feuchtigkeitsundurchlässige, vorzugsweise metallische Wanne gebildet, welche den ersten Bereich 2, auf dem die Eingangsschaltung angeordnet ist, begrenzt. Desweiteren wird nach dem Bestücken der Leiterplatte 4 mit Bauelementen (schematisch dargestellt ist lediglich ein Bauelement 30 der Eingangsschaltung) eine feuchtigkeitsundurchlässige Vergussmasse 24 auf Epoxy-Basis sowohl in die von der schlitzförmigen Ausnehmung 10 gebildete Vertiefung als auch über den gesamten ersten Bereich 2 vergossen. Es wurde festgestellt, dass eine derartige Einkapselung der Eingangsschaltung Feuchtigkeit weder von außen noch von innen zu der Eingangsschaltung gelangen lässt. Es ist möglich, mit konventionellen Leiterplattenmaterialien zu arbeiten, welche Feuchtigkeit aufnehmen und innerhalb der Leiterplatte leiten. Durch Vorsehen der feuchtigkeitsundurchlässigen Barriereschicht 20 in Form des Abschnitts 22 der Schicht 18 lässt sich der die Eingangsschaltung tragende zweite Bereich 2 der Leiterplatte 4 zum Inneren hin wirksam isolieren. Es tritt keine Feuchtigkeit in den zweiten Bereich 2 und damit zu dem hochohmigen Schaltungsteil. Nach außen hin bildet die Vergussmasse 24 einen feuchtigkeitsdichten Abschluss. Somit bleibt der bei der Herstellung existierende Zustand der Hochohmigkeit auch bei Betriebsbedingungen erhalten.

Die Ein- bzw. Ausleitung von Signalen zu bzw. von der Eingangsschaltung erfolgt über Widerstände 32, deren eines Pad im Inneren des gekapselten Bereichs liegt und deren anderes Pad im Äußeren zweiten Bereich 12 der Leiterplatte 4 liegt. Die Vergussmasse umschließt dabei den üblicherweise keramischen Körper des Widerstands 32 so, dass keine Feuchtigkeit eindringen kann. Die Kontaktierung des Messsignals des pH-Sensors kann über eine Teflon-Steckverbindung 34 erfolgen. Aufgrund der schlechten Haftung von Teflon mit den hier in Frage kommenden Vergussmaterialien ist jedoch der Teflon-Gehäusekörper des Steckverbinders 34 außerhalb der Vergussmasse 24 angeordnet, wobei sich dessen Pads jedoch durch die Vergussmasse 24 hindurch erstrecken.

Es wird darauf hingewiesen, dass derjenige mit den Bauteilen der Eingangsschaltung zu bestückende Oberflächenbereich der Leiterplatte, also der erste Bereich 2, nicht mit einer zusätzlichen Beschichtung, z.B. Lötstoplack, versehen ist, um die Hochohmigkeit zwischen den Leiterbahnen nicht zu gefährden.

## Patentansprüche

1. Aufbau zur Bildung einer Eingangsschaltung zur Aufnahme und Verarbeitung eines elektrischen Signals, wie eines Spannungsignals einer Spannungsquelle, insbesondere eines Sensors, wie eines elektrochemischen, induktiven oder optischen Sensors, wobei die Eingangschaltung einen sehr hohen Eingangswiderstand von wenigstens 10¹¹ Ohm aufweist und auf einer Leiterplatte (4) angeordnet ist, wobei ein erster Bauelemente (6, 8) der Eingangsschaltung tragender Bereich (2) der Leiterplatte (4) von einem zweiten ihn umgebenden oder an ihn angrenzenden Bereich (12) durch eine schlitzförmige Ausnehmung (10) getrennt ist, **dadurch gekennzeichnet, dass** die schlitzförmige Ausnehmung (10) im Innern der Leiterplatte (4) endet und in Dickenrichtung der Leiterplatte (4) bis zu einer den ersten Bereich (2) der Leiterplatte unterfangenden feuchtigkeitsundurchlässigen Barriereschicht (20) erstreckt ist und dass die schlitzförmige Ausnehmung (10) und der erste Bereich (2) mit einer zusammenhängenden feuchtigkeitsundurchlässigen Vergussmasse (24) aus- und umgossen sind.

2. Aufbau nach Anspruch 1, **dadurch gekennzeichnet, dass** die feuchtigkeitsundurchlässige Barriereschicht (20) eine metallische Schicht (18) ist.

3. Aufbau nach Anspruch 2, **dadurch gekennzeichnet, dass** die metallische Schicht (18) eine ebene Schicht innerhalb der Leiterplatte (4) bildet, die zumindest unterhalb des ersten Bereichs (2) ununterbrochen ausgebildet ist.

4. Aufbau nach Anspruch 1, 2 oder 3, **dadurch gekennzeichnet, dass** die Leiterplatte (4) von einem FR4-Material gebildet ist, welches zumindest eine feuchtigkeitsundurchlässige Barriereschicht (20) im Inneren aufweist.

5. Aufbau nach einem der vorstehenden Ansprüche, **dadurch gekennzeichnet, dass** die schlitzförmige Ausnehmung (10) begrenzende Wandungen (26) der Leiterplatte (4) mit einer feuchtigkeitsundurchlässigen Beschichtung (28) versehen sind.

6. Aufbau nach Anspruch 5, **dadurch gekennzeichnet, dass** die Beschichtung (28) von einer Metalllegierung gebildet ist, welche ihrerseits flüssigkeitsdicht an die Barriereschicht (20) anschließt.

7. Aufbau nach einem der vorstehenden Ansprüche, **dadurch gekennzeichnet, dass** die feuchtigkeitsundurchlässige Vergussmasse (24) auf Epoxy-Basis oder auf Basis eines HD-Polyethylen oder auf Schmelzharzbasis hergestellt ist.

8. Leiterkarte einer Messwertverarbeitungseinrichtung, insbesondere für einen Sensor, **gekennzeichnet durch** einen Aufbau nach einem der vorstehenden Ansprüche.

## Claims

1. Structure for creating an input circuit for receiving and processing an electrical signal, such as a voltage signal from a voltage source, particularly a sensor, such as an electrochemical, inductive or optical sensor, whereby the input circuit exhibits a very high input impedance of at least 10¹¹ Ohm and is arranged on a printed circuit board (4), where a first component (6, 8) of the input circuit is the load-bearing area (2) of the printed circuit board (4) and is separated from a second area (12) surrounding it or adjacent to it by means of a slot-like recess (10), **characterized in that** the slot-like recess terminates inside the printed circuit board (4) and extends in the through-thickness direction of the printed circuit board (4) to a first barrier layer (20) which does not let moisture penetrate and underlies the first area (2) of the printed circuit board, and **characterized in that** the slot-like recess (10) and the first area (2) are filled and enclosed by a cohesive potting compound (24) that does not allow moisture to penetrate.

2. Construction as per Claim 1, **characterized in that** the barrier layer (20) that does not let moisture through is a metal layer (18).

3. Construction as per Claim 2, **characterized in that** the metal layer (18) forms an even layer within the printed circuit board (4) which is uninterrupted under the first area (2) at least.

4. Construction as per Claim 1, 2 or 3, **characterized in that** the printed circuit board (4) is made from an FR4 material that at least exhibits a barrier layer (20) on the interior that does not allow moisture to penetrate.

5. Construction as per one of the previous Claims, **characterized in that** the walls (26) of the printed circuit board (4) that border the slot-like recess (10) are provided with a coating (28) that does not allow moisture to penetrate.

6. Construction as per Claim 5, **characterized in that** the layer (28) is formed by a metal alloy which is attached to the barrier layer (20) such that it is liquid-tight.

7. Construction as per one of the previous Claims, **characterized in that** the potting compound (24), which does not allow moisture to penetrate, is produced on an epoxy base or on a HD polyethylene base or on a liquid resin base.

8. A circuit card of a measured value processing unit, particularly for a sensor, **characterized by** being constructed in accordance with one of the previous claims.

## Revendications

1. Montage destiné à la constitution d'un circuit d'entrée pour l'enregistrement et le traitement d'un signal électrique, tel qu'un signal de tension d'une source de tension, notamment d'un capteur, tel qu'un capteur électrochimique, inductif ou optique, pour lequel le circuit d'entrée présente une résistance d'entrée très élevée d'au moins 10¹¹ ohms et est disposé sur le circuit imprimé (4), pour lequel une première zone support (2) du circuit imprimé (4) supportant des composants (6, 8) du circuit d'entrée est séparée d'une deuxième zone (12) l'entourant ou l'avoisinant, par un évidement (10) en forme de fente, **caractérisé en ce que** l'évidement (10) en forme de fente aboutit à l'intérieur du circuit imprimé (4) et, dans le sens de l'épaisseur du circuit imprimé (4), s'étend jusqu'à une couche barrière (20) imperméable à l'humidité supportant la première zone (2) du circuit imprimé (4), et **en ce que** l'évidement (10) en forme de fente et la première zone (2) sont enrobés par une masse d'enrobage (24) imperméable à l'humidité.

2. Montage selon la revendication 1, **caractérisé en ce que** la couche barrière (20) imperméable à l'humidité est une couche métallique (18).

3. Montage selon la revendication 2, **caractérisé en ce que** la couche métallique (18) constitue une couche plane à l'intérieur du circuit imprimé (4), qui est formée de façon ininterrompue au minimum au-dessous de la première zone (2).

4. Montage selon la revendication 1, 2 ou 3, **caractérisé en ce que** le circuit imprimé (4) est constitué d'un matériau FR4, lequel présente à l'intérieur au minimum une couche barrière (20) imperméable à l'humidité.

5. Montage selon l'une des revendications précédentes, **caractérisé en ce que** les parois (26) du circuit imprimé (4) bordant l'évidement (10) en forme de fente sont munies d'un revêtement (28) imperméable à l'eau.

6. Montage selon la revendication 5, **caractérisé en ce que** le revêtement (28) est constitué d'un alliage métallique, lequel borde à son tour de façon étanche à l'eau, la couche barrière (20).

7. Montage selon l'une des revendications précédentes, **caractérisé en ce que** la masse d'enrobage (24) imperméable à l'eau est fabriquée à base d'époxy ou à base d'un polyéthylène haute densité ou à base de résine fondue.

8. Circuit imprimé d'un dispositif de traitement de valeurs mesurées, notamment pour un capteur, **caractérisé par** un montage d'après l'une des revendications précédentes.
